# EUROPEAN PATENT APPLICATION

(11) **EP 2 230 130 A1**
(43) Date of publication of application: **22.09.2010**
(21) Application number: 09155760.3
(22) Date of filing: 20.03.2009
(51) Int. Cl.: B60Q 3/02

(54) **LED illumination module with touch sensitive controls and overhead console using the module**

(71) Applicant: SMR Patents S.à.r.l., 1653 Luxembourg (LU)
(72) Inventor: de Laine, Mark, Payneham, South Australia 5070 (AU); Olijnyk, Mark, Hallett Cove, South Australia 5158 (AU); de Kievit, Gary, O'Sullivan Beach, South Australia 5166 (AU)
(74) Representative: Rausch, Gabriele

(57) **Abstract**

The invention discloses an illumination module (MA) with LED means for illuminating interior of the vehicle and for establishing a map reading light, controlled by a touch sensitive switch. A further aspect of the invention shows an overhead console that encloses additional modules: module (MB) with means for switching a door light, module (MC) with a pivotable door member to form a compartment, module (ME) with touch sensitive switch for sun roof, module (MD) with LEDs for rear compartment illumination.

## Description

### Background of the invention

The invention is related to an illumination module as map reading light, ambient light and dome light combining LEDs and touch sensitive switches to one device.

The invention is in a further aspect an overhead compartment using the illumination module and combines different further functions. The overhead compartment is designed in a modular manner so that one functional part can be replaced by others. Modules are defined according their function and can be replaced by other functional modules. Especially the door for the sun glass compartment is replaced by a module cover part including touch sensitive switches and controls for a sun roof.

### State of the Art

Illumination Modules for use in overhead compartments are known in prior art. US 2008/0158900 discloses a module for a map reading light. The light source can be a white LED. The light is directed via reflector means. The control of the module is done by buttons arranged in the module. The document shows a solution in which lamps are located apart from the control buttons. Users must remember the right button to control the right lamp.

A touch sensitive switch for automotive use is disclosed in EP 11533405. The structure of the switch itself is an elongate depression 9 in the instrument panel created in the form of a wide groove which is elongate and substantially linear. The groove has a width and a depth to allow a finger to be slid along the groove and is deep enough to give the user a positive feel that his finger is correctly located without having to study the instrument panel carefully.

Overhead consoles with a drop down door for sun glasses or other small articles are known in prior art. US 6003925 describes a solution with an overhead console for a vehicle including a housing defining a transmitter storage compartment for a garage door opener and an opening for permitting access to the storage compartment. A door is pivotally mounted to the housing for movement between a closed position for covering the opening and an open position for exposing the interior of the compartment through the lower opening. A manually operable actuating member is mounted to the door for movement with respect thereto, and includes a plurality of sockets formed therein.

The overhead console comprises courtesy lights or installation area for other functions. The design is limited to an overhead compartment with a standard reading lamp and a conventional switch together with a storage means.

The invention of a lamp structure using a touch sensitive switch is known in prior art. GB2008/050274 describes a lamp which uses the lamp cover as the switch trigger. The design described is not intuitive to use, as the switch function is not clear to the user, especially during night-time operation, which is when the lighting operation is generally required.

The inventional illumination module uses a touch sensitive control system incorporated in the lamp structure. Therefore the user need not remember the button to control a lamp, or decode a symbol on a button, but can use the touch sensitive switch which is incorporated into the lamp design. According to another aspect the invention provides illumination of the desired switch touch area to highlight the switch contact point when in darkness.

It is a further intention of the invention to avoid globes taking up a lot of space in the assembly, as do the button sub-assemblies required for tactile switches. Consequently bulbs are replaced by LEDs with a long lifetime. The whole assembly process is eased, for the assembly needs fewer parts than commonly known illumination modules. This reduces in consequence the workload for the assembly process and the final weight of the module and the overhead console.

The inventional overhead solution uses a modular system wherein modules can easily replaced by others with different functions. Several modules can be replaced by others according the functions customer wants to realize.

A basic module is provided according the size of the overhead console recess of the vehicle. The basic module also includes several recesses for functional modules as ambient light module, card reading module, sunglass module, and sunroof control module.

The inventional overhead module designs a multi-functional overhead compartment using only a touch sensitive switch avoiding individual buttons per function and an intelligent touch sensitive switch control for the sunroof modular solution. As this solution avoids moving parts the risk that the overhead console rattles in use is reduced. All electrical functions are installed an implemented on printed circuit boards and can be pre assembled.

### Summary of the invention

The invention is shown in the figures and shortly described there after.
Figure 1 shows a plan view of overhead console assembly with sunglass compartment.
Figure 2 shows a section A-A: of the door switch
Figure 3 shows an alternative button illumination section view.
Figure 4 shows a button illumination detail.
Figure 5 shows a section B-B of central dome lamp
Figure 6 shows a section C-C of map reading lamp.
Figure 7 shows an alternative method for achieving map reading illumination targets.
Figure 8 shows a plan view of rear lighting module containing only map and dome lamps.
Figure 9 shows a plan view of an overhead console assembly with sunroof control switch.
Figure 10s shows a sunroof switch with top left button fascia, top right sided view bottom PCB touch sensitive button layout.

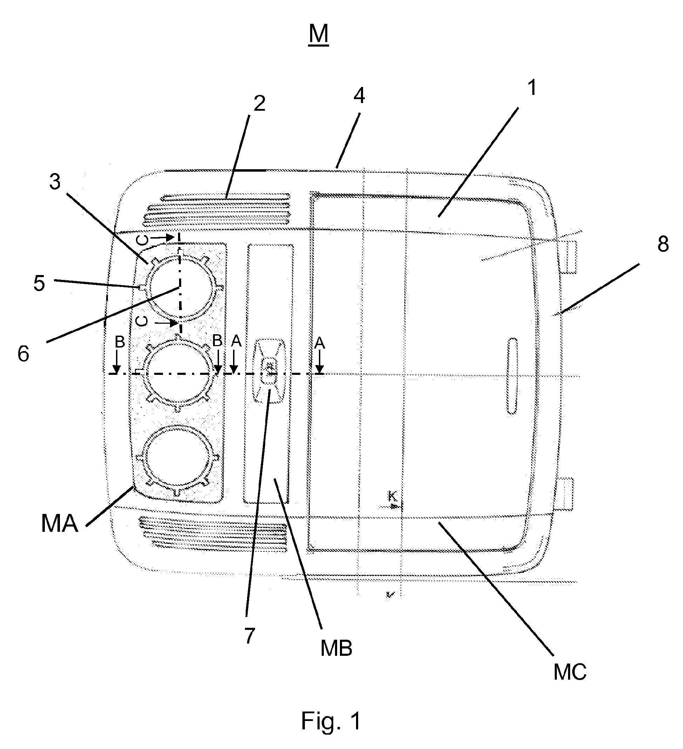

One example of the invention is shown in figure 1. A back cover of the overhead console is not shown in section views, but may be present in an assembly. The geometry of the components is not precise and may vary from what is shown.

An overhead console M consists of a housing 4, hosting different modules. In figure 1 three different modules are implemented: module MA with illumination means, module MB with switching means, and module MC with mechanical pivotable means.

The housing forms together with a back cover a framework for the modules. In the embodiment of figure 1 the framework includes a microphone grill structure 2, which can also be a loud speaker.

The mechanical module MC is a compartment in which to store items such as sunglasses. A pivotable door 1 covers the mechanical module MC. Each of the modules as described below in details are produced separately and can be replaced by other functional modules or a simple cover plates, if the module recess is not used.

Illumination module MA includes lamp covers 3 implemented in the module, covering a printed circuit board (PCB) with LEDs 6 and capacitive sensors to act as switching devices for LED control. The touch sensitive areas are shown as ring shaped structures 5 on the lamp cover 3. The module forms cavities for a dome lamp and map reading lamps both realized with LED lamps.

Module MB has a switch sensing area 7, which is realized in a depression on z- axis into the figure plane. In The embodiment of figure 1 is a symbol in center of depression, which will be moulded in to plastic or will be cut out with illuminated material behind. The module is used to provide a door switch function.

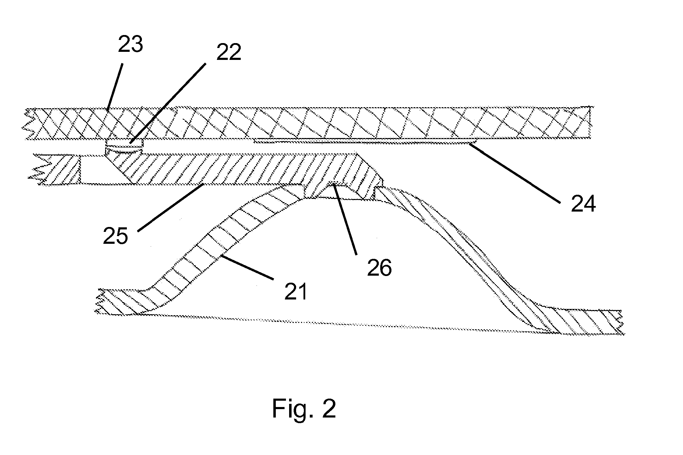

Figure 2 shows a detail of module MB section A-A: through a door switch.

The location of the switch is indicated to the user by a trough 21 in the surface of the module MB, and also by an illuminated symbol on translucent material 26 pressed into the top of the trough 21. An electrode 24 is printed onto a switch PCB 23 directly above the trough 21 which acts as the sensing element for the switch. A LED 22 is also directly installed onto the switch PCB 23. The light of this LED illuminating the button itself is guided by a section of the lamp cover or a lens 25 to the texture structure of the translucent material 26 at the bottom of the through 21. The switch is activated / deactivated by placing a finger into the trough 21 closing the electrical circuit by changing capacitance of the switch. The light from the button illumination LED 22 is piped by reflection through part of the lamp cover or lens 25. In another embodiment this light pipe is a separate part instead of being integral to the lamp cover or lens 25. Also any other touch sensitive structure can be used to realize the door switch in module MB.

These controls for the lighting, such as the dome lamp activation coinciding with the opening and closing of the vehicle doors have sensing areas directly behind the housing surface of the module MB. These areas are depressed in comparison to the surrounding surface and in the middle of this depression consist of a translucent material similar to a lens with a textured marking indicating the function of the switch. This translucent material is clipped or pressed into the housing of the module MB. The textured symbol is illuminated by a LED on the main board and the light disperses within the textured area during night driving. The touch sensitive areas are formed by conductive material printed on the PCB directly behind the switch area. The light from the LEDs is manipulated by way of optics in the lamp cover or additional lenses so that areas for map reading are illuminated.

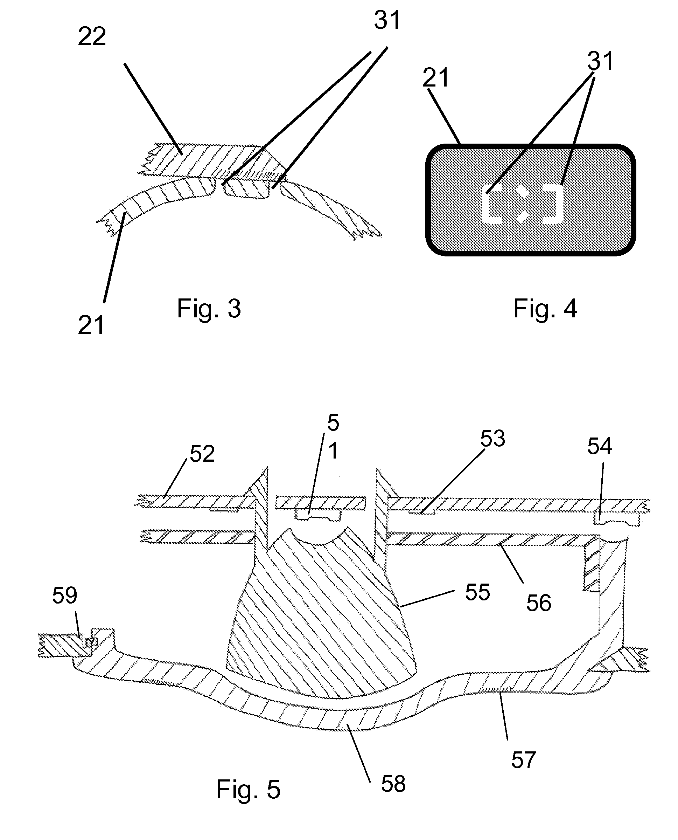

Figure 3 shows the detail of an alternative style of button illumination with a hole 31 in the shape of the button symbol, behind which is the illuminated translucent material. Figure 4 shows what the face of this button looks like schematically. The bottom is enclosed by an area being the plastic of the housing especially the module MB and the light part represents the gap or hole 31 through which the illuminated backing can be seen.

Figure 5 shows a cross section B-B through illumination module MA and a central dome lamp.

A dome lamp LED 51 is directly installed on a dome lamp PCB 52.

The sensing area for the dome lamp switches is circular in shape and concentric to the location of each of the LED clusters for dome lamp. The ring forming touch sensor electrodes 53 is surrounding LED 51 which can be a single LED or a LED cluster. The location of these touch sensitive switches is indicated by textured rings 57 on a lamp cover or lens 58 around each lamp. To illuminate the textured rings 57 on the cover 58 an additional LED 54 is installed on the PCB 52. During night driving this LED 54 illuminates the switch. These LEDs shine through the lamp cover from side on and use the dispersion effect of the rough texture to illuminate the sensing area around the lamps. In the embodiment of invention according figure 5, an optical piece 55 is mounted on the PCB 52. This optical piece modifies the cone of light from the LED 51 and provides desired illumination pattern fro the dome light. A light shield 56 covers the PCB 52 in direction of the lamp cover 58. Alternately, the switch contact areas may be illuminated by driving the dome lamp LED or LEDs themselves at a low current, with the switch function changing the current draw through the LED to alter the brightness.

To activate or deactivate the dome light, the user puts a finger on the textures and illuminated area 57.

Also for this embodiment the illumination of the touch sensitive switch marked by the textured ring is possible by using light guiding structures. Therefore the position of the button illumination LED can be optimized on the PCB. The light guiding structure can be a separate device or implemented into the lamp cover.

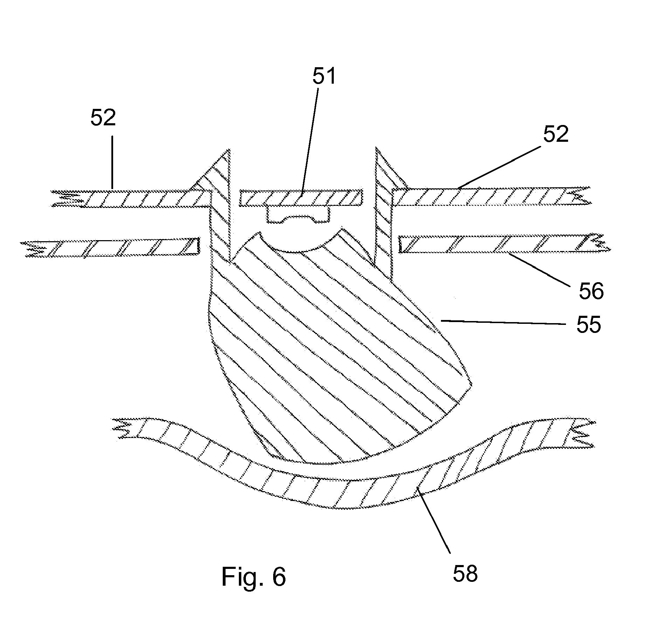

Figure 6 shows a cross section C- C through module MA and a map reading lamp.

The elements shown in this embodiment are similar to the dome lamp of figure 5. For the map reading lamp the optical piece 55 is chosen to be a skewed ellipsoid used for the outer LED lamps to cast light into the target areas for map reading. Alternate optic arrangements are possible, including optics incorporated into the lamp cover 58.

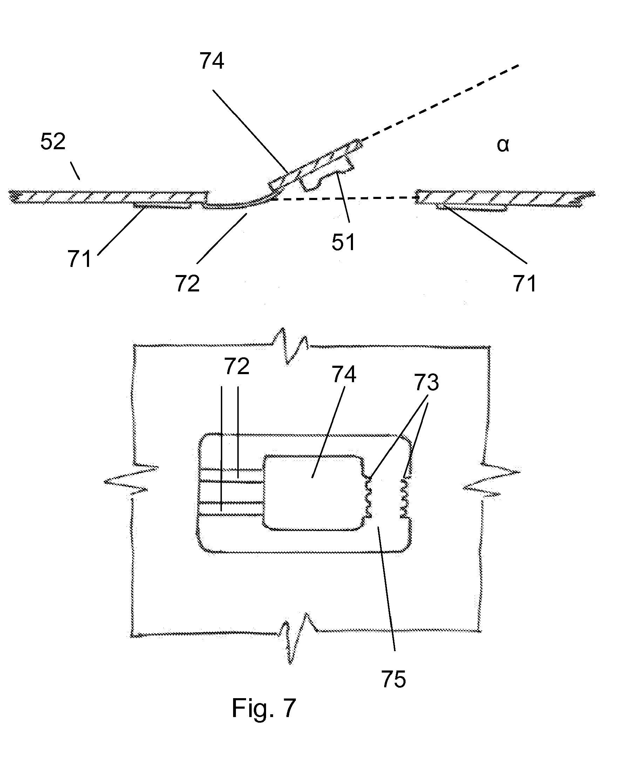

Figure 7 shows an alternative solution for a map reading illumination.

In this embodiment the optical piece directing light in a defined direction is replaced by a LED 51 on an angled part 74 of the printed circuit board 52.

This embodiment involves routing a channel 75 around the map lamp LED 51 on three sides and perforating around the fourth and outermost side. On the innermost side of the board 52 two thin flexible pressed metal terminals 72 join the isolated LED section of board 74 with. Post assembly of the PCB components, perforations are broken through to allow the LED section of board 74 to be manipulated to the desired incident angle alpha. In the overhead console assembly the flexible section of the board will be located to the desired angle by features on adjacent parts and fastened by the surrounding parts also.

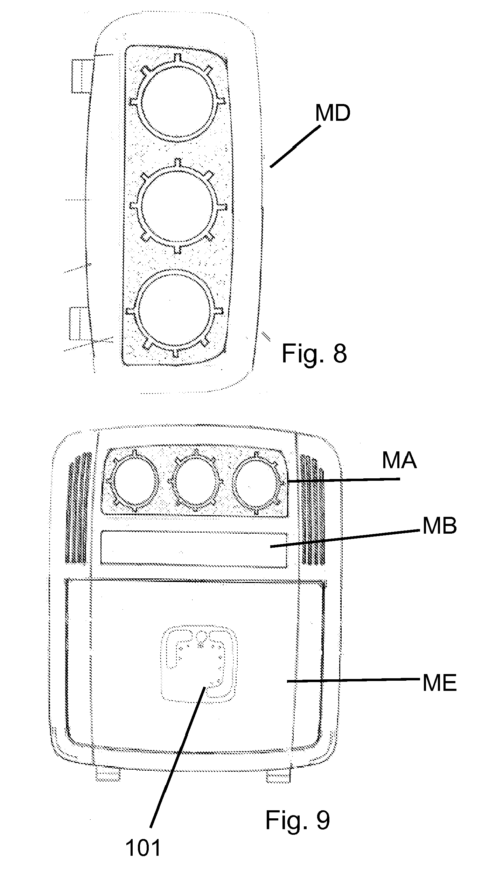

Figure 8 shows a plan view of a rear lighting module MD containing only map and dome lamps.

This module is a lamp only module which is located towards the rear of the vehicle and will have the touch sensors for the map lamps, but not the dome lamp. The front overhead console dome lamp switch acts as the master switch for both dome lamps. Lighting modules for the rear of the car will have the same lighting and switch set up with a smaller housing and no auxiliary switches aside from those that directly control the individual lamps. For aesthetics and also to act as a light shield between each section of the lamp i.e. map and dome there will be a layer of opaque material between the outer lamp cover and the PCB.

Figure 9 shows a plan view of an overhead console assembly with a sunroof control switch. This is module ME which is in this embodiment a sunroof switch module, that is clipped into a bezel replacing the sunglass bin compartment module MC. With the advantage of being able to create alternative button configurations, the sunroof switch 9 could also be made integral to the console housing without requiring an addition panel as in the above layout.

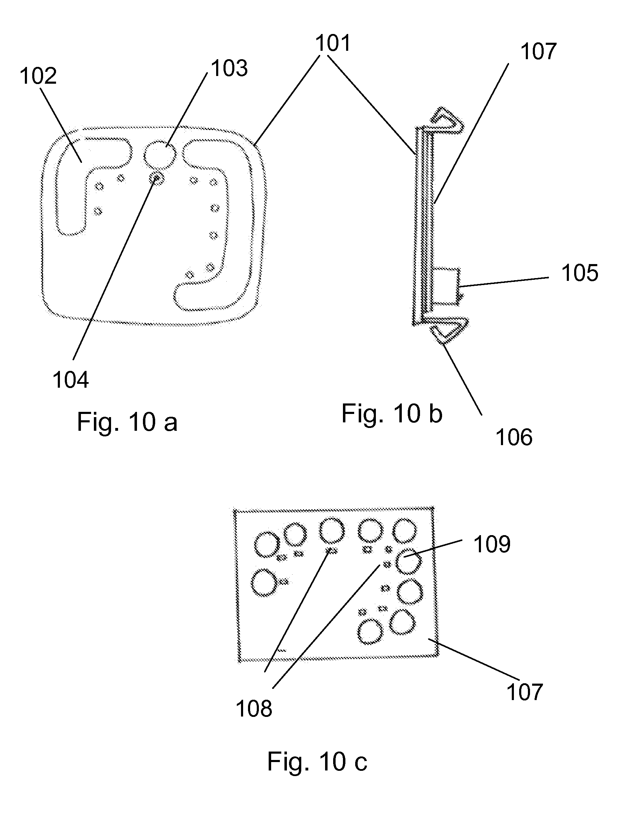

Figure 10, shows an embodiment of a sunroof switch with Fig. 10a showing a button fascia, Fig. 10b showing a side view and fig. 10c showing PCB touch sensitive button layout.

The sunroof controller is a touch sensitive switch arranged in such a fashion as to appear like a sliding touch control. The control switch fascia 101 has a trough 102 corresponding to the sensor locations 109.

The fascia also comprises an individual closed position depression 103 and indicator LEDs for current user selection. For the purpose of user feedback indicator LEDs may be used for all of the switches or even just one for the closed position. The light from these LEDs may shine directly into the fascia aperture in the case of having a painted and etched fascia or else as with the main console switches the light may be piped through an additional part made from translucent material allowing for an unpainted fascia.

Figure 10b shows the touch sensitive sun roof switch 9 with a PCB for the switch 107 covered by the translucent material.

The translucent material comprises clips 106 to assemble the sunroof switch into the overhead console bezel structure. Fig. 10 c shows the PCB 107 with touch sensitive switching electrodes 109 and indicator LED 108.

The orientation of the switches - which means the electrodes - is only limited by what can be printed on the PCB. Each switch location represents a location for the sunroof.

Light from individual LEDs 108 will need to be shielded to discreetly illuminate each position. This is done by a feature integral to the fascia 101 or an additional part located between the PCB 107 and fascia 101. A simple logic circuit would be used to convert the output into the required format for the sunroof control unit.

The sunroof control comprises a separate PCB with connector to interface with the vehicle harness 105 and also a fascia for the controller. The PCB is clipped or screwed to the fascia 101 and this sub-assembly is clipped or screwed into a panel on the face of the overhead console to form module ME. The sunroof control is a linear array of touch sensitive areas on the PCB and indicated on the switch surface by a depressed trough in the fascia. The orientation of the array has an irregular, linear or curved shape. The closed position of the sunroof may also have extra emphasis such as a raised area 103 in a ring shape inside the trough around the sensing area for this switch. The position of the sunroof that is the current selection of the user may be indicated by backlighting with LEDs either directly or indirectly by illuminating a textured symbol on the surface of a translucent material.

The users will touch their finger on the surface of the overhead console to activate or deactivate a function. In the case of the sunroof switch they are able to slide their finger along the trough to the desired opening position or simply touch in one position.

### Legend:

- 1: Door.
- 2: Microphone grill.
- 3: Lamp cover or lens.
- 4: Housing.
- 5: Textured shape
- 6: LED lamp
- 7: Door switch
- 8: Bezel
- 9: Sunroof Switch
- 2: 21Trough in Housing.
- 22: Button illumination LED.
- 23: Switch PCB.
- 24: Touch sensor electrode.
- 25: Light pipe.
- 26: Textured surface
- 31: Openings
- 51: Map Lamp LED.
- 52: PCB.
- 53: Ring sensor electrode
- 54: Button illumination LED.
- 55: Optic piece
- 56: Light Shield.
- 57: Textured surface.
- 58: Lamp Cover or Lens.
- 59: Housing.
- 71: Touch sensitive electrode.
- 72: Pressed metal contact.
- 73: Perforated area of PCB.
- 74: Broken section of PCB.
- 75: Channel
- 101: Button Fascia.
- 102: Trough.
- 103: Closed position depression.
- 104: Indicator LED
- 105: Connector.
- 106: Clip.
- 107: PCB.
- 108: Indicator LED
- 109: Touch sensitive electrode

## Claims

1. Illumination module (MA) with means (6) for illuminating interior of a vehicle and for establishing a map reading light, **characterized in that** the module MA consists of a PCB layer (52), light source (51), printed electrodes (53) for a touch sensitive switch on the PCB covered by a lens (58) in the module housing (59) and an illuminated zone (57) on the lens showing switch contact area for the touch sensitive switch.

2. Illumination module according to claim 1 **characterized in that** the module (MA) has an light directing means.(55, 74).

3. Illumination module according to claim 1 **characterized in that** the light directing means (55) has an optical piece forming the light shaped as a cone or as a skewed ellipsoid.

4. Illumination module according to claim 1 **characterized in that** the light directing mean is an angled part of the printed circuit board (52).

5. Illumination module according to claim 1 **characterized in that** the light directing means is integrated to the lens, and the light directing means acts as the illuminated zone.

6. Illumination module according to claim 4 **characterized in that** the angled part is connected via metal terminals (72) and is a break out of the printed circuit board.

7. Illumination module according to claim 1 **characterized in that** the illuminated zone is illuminated by a button illumination LED (54, 22)

8. Illumination module according to claim 7 **characterized in that** the light of the button illumination LED is directed to the illuminated zone (31) by a light guide (25).

9. Overhead console for a vehicle comprising a housing with a back plate, the housing includes recesses for modules with different functions and at least an illumination module according to one of the claims 1 to 8.

10. Overhead console for a vehicle according claim 9 **characterized in that** the further modules are selected from a group of modules: module MB with means for switching (7) a door light, module MC with a pivotable door member (1) to form a compartment, module ME with touch sensitive switch (9) for sun roof, module MD with LEDs for rear compartment illumination.

11. Overhead console according claim 9, **characterized in that** the module MB has a touch sensitive switch (7) with a trough (21) in the housing, an opening in the trough, and illumination of the opening.

12. Overhead console according claim 9 **characterized in that** the module MC has the same size as module ME.

13. Overhead console according claim 8 **characterized in that** the module ME comprises a touch sensitive switch (9) with troughs (102) in the surface of the housing of this module, the trough is covering touch sensitive locations (109) on the PCB (107).

14. Overhead console according claim 12 **characterized in that** the fascia (101) of the touch sensitive switch (9) comprises clips (106) to be fastened into module ME.

## Amended claims

### Amended claims in accordance with Rule 137(2) EPC.

**1.** Illumination module (MA) with means (6) for illuminating interior of a vehicle and for establishing a map reading light, **characterized in that** the module MA consists of a PCB layer (52), light source (51), printed electrodes (53) for a touch sensitive switch on the PCB covered by a lens (58) in the module housing (59) and an illuminated zone (57) on the lens showing switch contact area for the touch sensitive switch.

**2.** Illumination module according to claim 1 **characterized in that** the module (MA) has an light directing means (55, 74).

**3.** Illumination module according to claim 1 **characterized in that** the light directing means (55) has an optical piece forming the light shaped as a cone or as a skewed ellipsoid.

**4.** Illumination module according to claim 1 **characterized in that** the light directing mean is an angled part of the printed circuit board (52).

**5.** Illumination module according to claim 1 **characterized in that** the light directing means is integrated to the lens, and the light directing means acts as the illuminated zone.

**6.** Illumination module according to claim 4 **characterized in that** the angled part is connected via metal terminals (72) and is a break out of the printed circuit board.

**7.** Illumination module according to claim 1 **characterized in that** the illuminated zone is illuminated by a button illumination LED (54, 22)

**8.** illumination module according to claim 7 **characterized in that** the light of the button illumination LED is directed to the illuminated zone (31) by a light guide (25).

**9.** Overhead console for a vehicle comprising a housing with a back plate, the housing includes recesses for modules with different functions and at least an illumination module according to one of the claims 1 to 8.

**10.** Overhead console for a vehicle according claim 9 **characterized in that** the further modules are selected from a group of modules: module MB with means for switching (7) a door light, module MC with a pivotable door member (1) to form a compartment, module ME with touch sensitive switch (9) for sun roof, module MD with LEDs for rear compartment illumination.

**11.** Overhead console according claim 9, **characterized in that** the module MB has a touch sensitive switch (7) with a trough (21) in the housing, an opening in the trough, and illumination of the opening.

**12.** Overhead console according claim 9 **characterized in that** the module MC has the same size as module ME.

**13.** Overhead console according claim 8 **characterized in that** the module ME comprises a touch sensitive switch (9) with troughs (102) in the surface of the housing of this module, the trough is covering touch sensitive locations (109) on the PCB (107).

**14.** Overhead console according claim 12 **characterized in that** the fascia (101) of the touch sensitive switch (9) comprises clips (106) to be fastened into module ME.
